# EUROPÄISCHE PATENTSCHRIFT

(11) **EP 0 297 443 B1**
(45) Veröffentlichungstag und Bekanntmachung des Hinweises auf die Patenterteilung: **08.06.1994**
(21) Anmeldenummer: 88110062.2
(22) Anmeldetag: 24.06.1988
(51) Int. Cl.: G03F 7/004, G03F 7/075

(54) **Strahlungsempfindliches Gemisch für lichtempfindliche Beschichtungsmaterialien**
Light sensitive mixture for light sensitive coating materials
Mélange photosensible pour matériaux de revêtement photosensibles

(30) Priorität: 01.07.1987 DE 3721741
(43) Veröffentlichungstag der Anmeldung: 04.01.1989
(73) Patentinhaber: BASF Aktiengesellschaft, 67063 Ludwigshafen (DE)
(72) Erfinder: Schwalm, Reinhold Dr., D-6706 Wachenheim (DE); Boettcher, Andreas Dr., D-6907 Nussloch (DE); Binder, Horst, D-6840 Lampertheim (DE)

(56) Entgegenhaltungen:
- EP-A- 0 146 411
- DE-A- 3 628 046
- JP-A- 6 238 450
- JOURNAL OF IMAGING TECHNOLOGY, vol. 11, no. 4, August 1985, Springfield, US, Seiten 146-147; S.P. Papas: "Photogeneration of Acid: Part 6 - A Review of Basic Principles for Resist Imaging Applications"

## Beschreibung

Die Erfindung betrifft strahlungsempfindliche Gemische, die ein wasserlösliches, aber in wäßrig-alkalischen Lösungen lösliches polymeres Bindemittel und eine organische Verbindung enthalten, die mindestens eine durch Säure spaltbare Bindung enthält und unter Einwirkung von Strahlung eine starke Säure bildet, wobei die Löslichkeit dieser organischen Verbindung in wäßrig-alkalischem Lösungsmittel durch die Einwirkung der Säure erhöht wird. Diese Gemische sind sensitiv gegenüber UV-, Elektronen- und Röntgenstrahlung und eignen sich besonders als positiv arbeitende Resistmaterialien.

Positiv arbeitende strahlungsempfindliche Gemische sind bekannt. Positiv arbeitende Resistmaterialien, die o-Chinondiazide in wäßrig-alkalischen Bindemitteln, z.B. Novolake oder Poly-(p-vinylphenol), enthalten, werden kommerziell als Fotoresiste eingesetzt. Die Empfindlichkeit dieser Systeme gegenüber Strahlung ist jedoch teilweise unbefriedigend.

Eine drastische Empfindlichkeitserhöhung in strahlungsempfindlichen Systemen erhält man, wenn man in der Primärfotoreaktion eine Spezies erzeugt, die dann unabhängig von der Strahlung eine katalytische Sekundärreaktion auslöst und dadurch die Quantenausbeute auf Werte oberhalb 1 steigert.

Solche Systeme, die fotochemisch eine starke Säure erzeugen, die dann in einer Sekundärreaktion säurelabile Gruppen spalten, sind z.B. aus US-PS 3 915 706 für positiv arbeitende Polyaldehyde bekannt.

Weiterhin sind strahlungsempfindliche Gemische auf Basis von säurespaltbaren Verbindungen bekannt, die als Bindemittel ein wäßrig-alkalisch lösliches Polymer, sowie eine Verbindung, die fotochemisch eine starke Säure bildet und eine weitere Verbindung, die durch Säure spaltbare Bindungen besitzt, enthalten (vgl. DE-A 34 06 927). Solche 3-Komponentensysteme sind auch aus der Literatur als Röntgenresiste bekannt (vgl. z.B. K. Dössel u.a., Microcircuit Engineering, Interlaken 1986).

Strahlungsempfindliche 2-Komponentengemische von Polymeren mit säurelabilen Seitengruppen und fotochemischen Säurespendern sind z.B. aus US-PS 4 491 628 und FR-PS 2 570 844 bekannt. Diese polymeren Bindemittel sind jedoch hydrophob und werden erst nach der Belichtung alkalilöslich.

Die Verwendung von Oniumsalzen als fotochemische Säurespender ist beispielsweise aus Anwendungen als kationische Polymerisationsinitiatoren (US-PS 4 058 400, US-PS 4 210 449), sowie in der oben bereits erwähnten US-PS 4 491 628 in Resistmaterialien bekannt. Einen Überblick über die Anwendung in Resistmaterialien gibt Crivello in Org. Coatings and Appl. Polym. Sci., 48, p. 65-69 (1985).

In Journal of Imaging Technology, Vol. 11, No. 4 (1985), Seiten 146 - 157, wird die Verwendung von Oniumsalzen für die kationische Photopolymerisation beschrieben.

Der EP-A-0 146 411 sind strahlungsempfindliche Zusammensetzungen aus alkalilöslichem phenolischen Harz und strahlungsempfindlichem Oniumsalz zu entnehmen.

In DE-A-3 628 046 und JP-A-62 038 450 werden photosolubilisierbare Zusammensetzungen beschrieben, die eine Verbindung, die beim Bestrahlen eine Säure bildet (a), und eine hochmolekulare Verbindung mit säurespaltbaren Gruppierungen (b) enthalten. Bei der zweiten hierin angegebenen Ausführungsform erfüllt die hochmolekulare Verbindung (c) die Funktion von (a) und (b), d.h. sie enthält eine Gruppierung, die beim Bestrahlen eine Säure bildet und eine Gruppierung, die durch den Einfluß von Säure zersetzt wird. Die hier beschriebene photosolubilisierbare Zusammensetzung enthält zusätzlich ein alkalilösliches Harz. Kombinationen unterschiedlicher hochmolekularer Verbindungen sind jedoch problematisch, da sich aus ihnen nur selten homogene Mischungen herstellen lassen.

Aufgabe der vorliegenden Erfindung war es, neue strahlungsempfindliche Systeme mit hoher Photoreaktivität für die Herstellung von Reliefstrukturen zur Verfügung zu stellen, die eine möglichst geringe Anzahl an Komponenten aufweisen und die Photoreaktivität in einem möglichst großen Bereich des Spektrums elektromagnetischer Wellen zeigen.

Überraschenderweise wurde gefunden, daß sich Verbindungen synthetisieren lassen, die im Molekül säurelabile Gruppen aufweisen und gleichfalls bei Bestrahlung eine starke Säure bilden, die die säurelabilen Gruppen spaltet und damit die Löslichkeitseigenschaften dieser Verbindung drastisch ändert. In Kombination mit einem filmbildenden alkalilöslichen Bindemittel erhält man so sehr vorteilhafte Systeme für die Herstellung von Reliefstrukturen.

Gegenstand der vorliegenden Erfindung sind strahlungsempfindliche Gemische, enthaltend
a) ein in Wasser unlösliches, in wäßrig-alkalischen Lösungen lösliches polymeres Bindemittel und
b) eine monomere organische Verbindung, deren Löslichkeit in einem wäßrigalkalischen Entwickler durch Einwirkung von Säure erhöht wird und die sowohl mindestens eine durch Säure spaltbare Gruppierung,
als auch eine Gruppierung enthält, die unter Einwirkung von Strahlung eine starke Säure bildet.

Als polymere Bindemittel a) kommen sowohl phenolische Harze, wie z.B. Novolake, Poly-(p-hydroxistyrol), Poly-(p-hydroxi-methylstyrol) oder Copolymere von p-Hydroxistyrol oder p-Hydroxi-methylstyrol, als auch Copolymerisate mit Carboxylgruppen, wie z.B. Methylmethacrylat/-Methacrylsäure-Copolymerisate in Betracht.

Bevorzugt sind solche organische Verbindungen b), die mindestens eine Oniumsalzgruppierung und mindestens eine t-Butylcarbonatgruppierung oder mindestens eine Silylethergruppierung enthalten.

Besonders bevorzugte derartige organische Verbindungen b) sind solche der allgemeinen Formel (I), 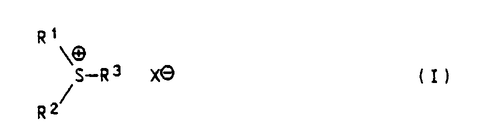
worin R¹ , R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure spaltbare Gruppierungen, verknüpft sein kann und X^{⊖} ein nichtnukleophiles Gegenion bedeutet, wie z.B. Dimethyl-4-t-butoxicarbonyloxiphenyl-sulfoniumsalz mit Hexafluoroarsenat, Hexafluoroantimonat, Hexafluorophosphat und/oder Tetrafluoroborat als Gegenion, Phenyl-bis-(4-t-butoxicarbonyloxiphenyl-)sulfoniumsalz mit Hexafluoroarsenat, Hexafluoroantimonat, Hexafluorophosphat und/oder Tetrafluoroborat als Gegenion, Tris-(4-t-butoxicarbonyloxiphenyl-)-sulfoniumsalz mit Hexafluoroarsenat, Hexafluoroantimonat, Hexafluorophosphat und/oder Tetrafluoroborat als Gegenion oder 1-Naphthyl-4-trimethylsilyloxitetramethylen-sulfoniumsalz mit Hexafluoroarsenat, Hexafluoroantimonat, Hexafluorophosphat und/oder Tetrafluoroborat als Gegenion.

Gegenstand der vorliegenden Erfindung sind auch die Verwendung dieser strahlungsempfindlichen Gemische in lichtempfindlichen Beschichtungsmaterialien, sowie ein Verfahren zur Herstellung von Reliefmustern und Reliefbildern, wobei man als lichtempfindliche Beschichtungsmaterialien erfindungsgemäße strahlungsempfindliche Gemische einsetzt und nach der Belichtung auf Temperaturen zwischen 60 und 120°C erhitzt.

Strahlungsempfindliche Gemische gemäß der vorliegenden Erfindung bestehen also im wesentlichen aus einem in Wasser unlöslichen, in wäßrig-alkalischen Lösungsmitteln jedoch löslichen polymeren Bindemittel (a) und einer organischen Verbindung (b), die säurespaltbare Gruppen enthält und bei Bestrahlung eine starke Säure bildet. Dieses strahlungsempfindliches Gemisch kann z.B. als dünner Film auf ein Substrat aufgebracht, zur Entfernung des Restlösungsmittels unter kontrollierten Bedingungen ausgeheizt, bildmäßig belichtet und erneut unter kontrollierten Bedingungen ausgeheizt werden. Die bildmäßig belichteten Bereiche werden durch diese Behandlung in ihrer Löslichkeit so verändert, daß ein vollständiger Abtrag mit wäßrig-alkalischen Lösungen, die gegebenenfalls polare Lösungsmittel, wie z.B. Isopropanol enthalten können, erfolgt, während die nicht belichteten Bereiche nur geringen Abtrag zeigen.

Die erfindungsgemäßen strahlungsempfindlichen Gemische sind sensitiv gegenüber Röntgen- , Elektronen- und kurzwelligen UV-Strahlen und können durch Zusatz eines Sensibilisators bis in den Bereich des sichtbaren Lichtes sensibilisiert werden. Im kurzwelligen UV-Bereich (< 300 nm) werden besonders Sulfoniumverbindungen bevorzugt eingesetzt, da deren Absorptionsmaxima unterhalb 300 nm liegen.

Zu den Aufbaukomponenten des erfindungsgemäßen strahlungsempfindlichen Gemisches ist im einzelnen folgendes auszuführen.

Als polymere Bindemittel (a) können alle in Wasser unlöslichen, in wäßrigalkalischem Medium jedoch löslichen oder dispergierbaren Polymeren eingesetzt werden, bevorzugt jedoch solche alkalisch löslichen Polymeren, die einen hohen Anteil an aromatischen Gruppen enthalten, wie beispielsweise Novolake, z.B. solche auf Basis von Phenol/Formaldehyd, wie sie beispielsweise in Plastics for Electronics, M.T. Goosey, Elsevier Appl. Sci. Publ. London, S. 220 u. 302, (1985) beschrieben sind, Poly-(p-hydroxystyrol), Poly-(p-hydroxymethylstyrol, sowie Copolymerisate von p-Hydroxystyrol und/oder p-Hydroxymethylstyrol mit anderen Monomeren, wie z.B. Styrole, (Meth)acrylnitril, (Meth)acrylsäure und Ester derselben. Die polymeren Bindemittel (a) mit einem hohen aromatischen Anteil haben den Vorteil, daß sie relativ stabil in Plasma- und reaktiven Ionenätzverfahren sind.

Gemäß der vorliegenden Erfindung können alle organischen Verbindungen (b), welche unter Bestrahlung Säure bilden und säurelabile Gruppen enthalten in Verbindung mit einem alkalilöslichen polymeren Bindemittel (a) eingesetzt werden. bevorzugt sind jedoch Oniumsalze, insbesondere Sulfoniumsalze der allgemeinen Formel (I): 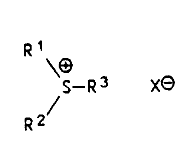
worin R¹ , R² und R³ untereinander gleich oder verschieden sind und für aromatische und/oder aliphatische Reste, die gegebenenfalls Heteroatome enthalten können, mit der Maßgabe, daß mindestens einer der Reste R¹ bis R³ eine säurespaltbare Gruppe. beispielsweise t-Butylcarbonate von Phenolen bzw. Silylether von Phenolen, enthält. Diese säurelabilen Gruppen sind bevorzugt, jedoch können eine große Zahl weiterer säurelabiler Gruppen, wie die bekannten Orthoester, Trityl- und Benzylgruppen sowie t-Butylester von Carbonsäuren ebenfalls verwendet werden. Es können auch zwei oder mehrere Sulfoniumeinheiten im Molekül über die Reste R¹ bis R³ verknüpft sein. Die organischen Verbindungen (b) werden im allgemeinen in Mengen von 5 bis 75, bevorzugt 10 bis 50 Gew.% und das polymere Bindemittel (a) in Mengen von 25 bis 95, bevorzugt 50 bis 90 Gew.%, bezogen auf die Gesamtmenge des strahlungsempfindlichen Gemisches, eingesetzt.

Bevorzugte Sulfoniumsalze der allgemeinen Formel (I) 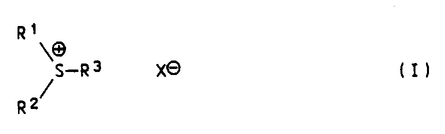
sind solche, in denen R¹ und R² für Methylgruppen und R³ für substituierte Phenylderivate mit säurespaltbaren Gruppen stehen, 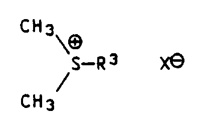
worin R³ z.B. für 4-t-Butoxicarbonyloxi-phenyl-, 4-t-Butoxicarbonyloxi-3,5-dimethyl-phenyl-, 4-t-Butoxicarbonyloxi-3-methyl-phenyl-, 4-t-Butoxicarbonyloxi-2-methyl-phenyl-, 4-t-Butoxicarbonyloxi3,5-dimethoxi-phenyl-, 4-t-Butoxicarbonyloxi-3,5-diphenyl-phenyl-, 1-t-Butoxicarbonyloxi-naphthyl-, 4-Trimethylsilyl-oxi-phenyl-, 4-Trimethylsilyl-oxi-napththyl- stehen oder auch solche, in denen zwei der Reste R¹ bis R³ miteinander zu einem Ring, insbesondere einem fünf- oder sechsgliedrigen Ring verknüpft sind, wobei z.B. R¹ und R² beispielsweise zu Tetramethylengruppen verbrückt sind und R³ die gleiche Bedeutung wie vorstehend hat: 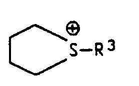
oder Verbindungen, in denen R¹ für Methyl und R² für Phenyl bzw. Tolyl stehen und R³ für ein substituiertes Phenylderivat mit säurespaltbaren Gruppen steht, wie 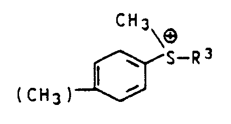
worin R³ z.B. für 4-t-Butoxicarbonyloxi-phenyl-, 2,4-Di-t-butoxicarbonyloxiphenyl-, 4-t-Butoxicarbonyloxi-2-methoxi-phenyl-, 4-Trimethylsilyl-phenyl- steht,
oder worin R¹ für Phenyl oder C₁- bis C₁₂-substituiertes Phenyl oder halogensubstituiertes Phenyl steht und R² und R³ substituierte Phenylderivate mit säurespaltbaren Gruppen sind, wie z.B. 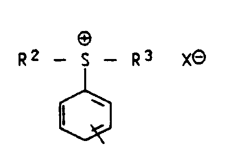
worin R² und R³ z.B. 4-t-Butoxicarbonyloxi-phenyl-, 4-Trimethylsilyloxiphenyl-, 4-t-Butyl-dimethyl-silyloxi-phenyl-, 4-t-Butoxicarbonyloxi3,5-dimethyl-phenyl- oder R¹, R² und R³ untereinander gleich sind, d.h. Sulfoniumsalze (b), in denen diese Reste mit säurespaltbaren Gruppen dreimal enthalten sind.

Weiterhin kommen auch Verbindungen der allgemeinen Formel (I) in Betracht, worin einer der Reste R¹ bis R³ mit einem oder mehreren weiteren Sulfoniumsalzresten, gegebenenfalls über durch Säure spaltbare Gruppierungen verknüpft ist, die also ebenfalls mehrere Sulfoniumgruppen im Molekül aufweisen, wie z.B. 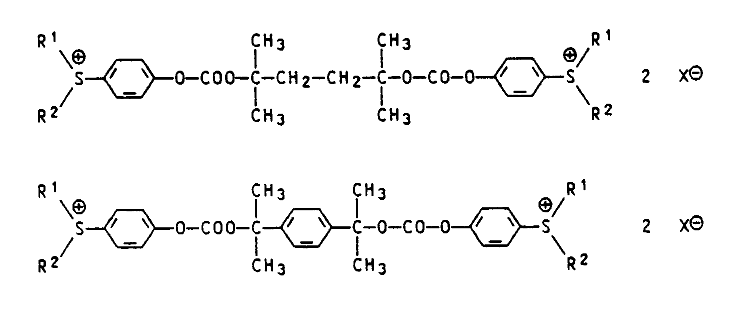
Neben den Sulfoniumsalzen kommen auch Iodoniumsalze in Betracht, wie z.B. 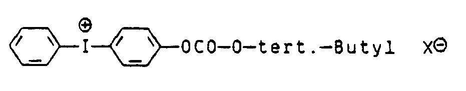
Als Gegenionen kommen bevorzugt komplexe Metallhalogenide, wie Tetrafluoroborat, Hexafluoroantimonat, Hexafluoroarsenat und Hexafluorophosphat in Betracht, jedoch ist die Erfindung nicht auf diese speziellen Gegenionen noch auf die aufgeführten Verbindungen mit säurespaltbaren Gruppen beschränkt, vielmehr können alle Verbindungen verwandt werden, welche unter Bestrahlung eine starke Säure bilden und im gleichen Molekül eine säurespaltbare Bindung enthalten.

Die organischen Verbindungen (b) können nach den bekannten Methoden der organischen Chemie zur Synthese von Estern, Ethern und Carbonaten hergestellt werden, indem man von den Sulfoniumsalzen mit phenolischen Gruppen ausgeht und diese entsprechend derivatisiert. Ausgehend von Sulfoniumsalzen mit phenolischen Gruppen können diese mit Kalium-t-butylat umgesetzt werden, anschließend kann mit Di-t-butyl-dicarbonat die säurespaltbare Gruppe eingeführt oder alternativ das phenolische Sulfoniumsalz mit einer aktivierten Carbonylverbindung, z.B. dem t-Butyloxi-carbonyl-N-imidazol, umgesetzt werden. Für diese Umsetzung eignen sich insbesondere Hydroxiphenyl-sulfoniumsalze, die bereits ein nichtnucleophiles Anion, wie z.B. Hexafluoroarsenat oder Hexafluoroantimonat enthalten. Solche Verbindungen können beispielsweise nach einer Synthesevorschrift in J. Polym. Sci., Chem. Ed., 18, 1021 (1980), hergestellt werden. Man kann beispielsweise die so hergestellten Verbindungen in trockenem Tetrahydrofuran lösen, Kalium-t-butylat in trockenem Tetrahydrofuran zugeben und anschließend eine Lösung von Di-t-butyl-dicarbonat in Tetrahydrofuran zutropfen. Nach der Aufarbeitung und Umkristallisation erhält man dann die reinen Sulfoniumsalze mit säurelabilen Gruppen.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt. daß die Löslichkeit der belichteten Bereiche in wäßrig-alkalischen Lösungsmitteln zunimmt und diese bestrahlten Bereiche selektiv mit dem alkalischen Entwickler entfernt werden können. Dazu werden die Verbindungen mit säurespaltbaren Gruppen, die unter Bestrahlung eine starke Säure erzeugen, die katalytisch die säurelabilen Gruppen abspaltet und damit die Löslichkeit der Verbindung in alkalischen Entwicklern erhöht, in Kombination mit einem alkalischen Bindemittel verwendet.

Vorzugsweise wird z.B. das polymere Bindemittel (a) und 25 Gew.% eines erfindungsgemäßen Oniumsalzes (b), bezogen auf den Feststoffgehalt des strahlungsempfindlichen Gemisches, in Methyl-glykol-acetat oder Methylpropylenglykol-acetat gelöst, wobei der Feststoffgehalt zwischen 10 und 30 Gew.% beträgt. Die Lösung kann durch ein Filter mit einem Porendurchmesser von 0, 2 »m filtriert werden. Durch Aufschleudern der Resistlösung bei Umdrehungszahlen zwischen 1000 und 10 000 U/min wird ein Resistfilm auf einem Siliziumwafer erzeugt. Der Wafer wird dann zwischen 1 und 5 Minuten bei 90°C bzw. 80°C ausgeheizt. Die Filme werden dann durch eine chrombeschichtete strukturierte Quarzmaske mit UV-Licht einer Quecksilber-Hochdrucklampe, mit Excimer-Laserlicht, Elektronenstrahlen oder Röntgenstrahlen bestrahlt. Die bestrahlten Filme werden zwischen 5 Sekunden und 2 Minuten bei Temperaturen zwischen 60 und 100°C ausgeheizt. Die so behandelten Filme werden hierauf mit alkalischen oder alkoholischen Entwicklern entwickelt, wobei sich die belichteten Bereiche selektiv ablösen, während in den unbelichteten Bereichen nur wenig Abtrag stattfindet.

Gegebenenfalls können Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind bevorzugt, jedoch können auch andere Farbstoffe, die als Sensibilisatoren wirken, verwendet werden.

Die in den folgenden Beispielen angegebenen Teile und Prozente beziehen sich, soweit nicht anders angegeben, auf das Gewicht.

### Synthese von Dimethyl-4-t-butoxicarbonyloxi-phenyl-sulfoniumhexafluoroarsenat

Dimethyl-4-hydroxiphenyl-sulfonium-hexafluorsenet wird gemäß der Synthesevorschrift in J. Polym. Sci., Polym. Chem. Ed., 18, 1021 (1980). hergestellt. Aus Phenol und Dimethylsulfoxid in Methanol unter Durchleitung von trockenem HCl wird zuerst das Sulfoniumchlorid erhalten, welches in einer anschließenden Methathesereaktion mit Kaliumhexafluoroarsenat in Dimethyl-4-hydroxiphenyl-sulfonium-hexafluoroarsenat überführt wird.

2,0 Teile dieses Salzes werden in 55 Teilen trockenem Tetrahydrofuran (= THF) unter N₂-Durchleitung gelöst. Dann wird 1 Teil Kalium-t-butylat zugegeben und anschließend 10 Minuten gerührt. Dazu tropft man eine Lösung von 1,27 Teilen Di-t-butyl-dicarbonat in 10 Teile Tetrahydrofuran und rührt eine Stunde nach. Die Reaktionsmischung wird in 50 Teile Eiswasser gegeben und mit Ethylacetat mehrmals extrahiert. Die kombinierte Ethylacetatfraktionen werden über Magnesiumsulfat getrocknet und Ethylacetat wird anschließend abgezogen. Das so erhaltene Rohprodukt wird zweimal aus Ethanol umkristallisiert. Man erhält das reine Dimethyl-4-t-butoxicarbonyloxi-phenyl-sulfonium-hexafluoroarsenat in einer Ausbeute von 1,5 Teilen.

### Prüfung:

Mittels NMR 1,5 ppm (S, 9H) : 3,3 ppm (S, 6H) : 7,65 ppm und 8,15 ppm (para-subst. Arom. je D, 4H)
IR Ar-O-CO-O-aliph. 1760 cm-¹;

| Elementaranalyse | C | H | S | As | F |
|---|---|---|---|---|---|
| gef. | 35,0 | 4,3 | 7,6 | 16,7 | 25,4 |
| ber. | 35,1 | 4,3 | 7,2 | 16,9 | 25,7 |

Das Dimethyl-4-t-butoxicarbonyloxiphenyl-sulfonium-hexafluoroarsenat erhält man auch durch Umsetzung des Dimethyl-4-hydroxiphenyl-sulfoniumhexafluoroarsenats (3,3 Teile) mit Imidazol-N-carbonsäure-t-butylester (1,9 Teile) in 15 Teilen Tetrahydrofuran. Das Reaktionsgemisch wird 8 Stunden auf 70°C erwärmt. Nach dem Abkühlen wird das Tetrahydrofuran abdestilliert und der Rückstand aus Ethanol umkristallisiert.

Analog können auch andere Salze, wie Hexafluoroantimonat und Hexafluorophosphat hergestellt werden.

### Synthese von Phenyl-bis-(4-t-butoxicarbonyloxiphenyl)-sulfoniumhexafluoroarsenat

In einem 100 ml-Zweihalskolben mit Rückflußkühler und Magnetrührer werden unter N₂-Durchleitung 11,75 g (0,025 mol) Diphenyliodoniumhexafluoroarsenat, 5,46 g (0,025 mol) 4,4' -Dihydroxi-diphenylsulfid und 0,2 g Kupfer(II)-acetat vorgelegt. Die Mischung wird unter Stickstoff 3 Stunden auf 125°C erhitzt, anschließend in ein Becherglas gegeben und mehrere Male mit Diethylether extrahiert. Das Rohprodukt wird aus Chloroform/Diethylether umkristallisiert. Ausbeute: 6,3 g. NMR- und IR-Spektren zeigen, daß das so hergestellte Produkt Phenyl-bis-(4-hydroxiphenyl-)-sulfoniumhexafluoroarsenat ist.

6,3 g des synthetisierten Phenyl-bis-(4-hydroxiphenyl)-sulfoniumhexafluoroarsenates werden in 100 ml trockenem Tetrahydrofuran unter N₂-Durchleitung gelöst. Dann gibt man 2,9 g Kalium-t-butylat zu und rührt anschließend noch 10 min nach. Dazu tropft man 6,24 g Di-t-butyldicarbonat in 20 ml THF und rührt eine weitere Stunde nach. Die Reaktionsmischung wird in 150 g Eiswasser gegeben und mit Ethylacetat mehrmals extrahiert. Die kombinierten Ethylacetatfraktionen werden über Magnesiumsulfat getrocknet und das Lösungsmittels wird abgezogen. Nach dem Umkristallisieren erhält man 7,0 g reines Phenyl-bis-(4-t-butoxicarbonyloxiphenyl)-sulfonium-hexafluoroarsenat.
NMR 1,5 ppm (S, 18H) : 7,5 ppm (D, 4H) : 7,7 ppm (M, 5H) 7,8 ppm (D, 4H)
IR (C=0, Carbonat) 1760 cm-¹
Schmelzpunkt: 128°C.

### Synthese von 4-(1-Trimethylsilyloxynaphthyl)tetrahydrothiophenium-hexafluoroarsenat

5,3 Teile 4-(1-Hydroxynaphthyl-)tetrahydrothiophenium-hexafluoroarsenat werden vorgelegt und 2 Teile Hexamethyldisilazan bei 25°C während 45 Minuten zugetropft. Es werden weitere 4,5 Teile Hexamethyl-disilazan zugegeben. Dann läßt man das Gemisch 7 Stunden bei 100°C reagieren. Von der entstehenden gelben Lösung wird das überschüssige Hexamethyl-disilazan unter Ölpumpenvakuum abdestilliert. Es bleiben 6,5 Teile eines gelben Öles zurück. Das NMR-Spektrum entspricht dem erwarteten silylierten Produkt.

### Prüfung von Phenyl-bis-(4-t-butoxicarbonyloxi-phenyl)-sulfoniumhexafluoroarsenat

Das Sulfoniumsalz wird im Gelblicht auf eine Natriumchloridplatte aufgebracht und 30 Sekunden bei 120°C ausgeheizt. Das IR-Spektrum zeigt eine scharfe Carbonylbande bei 1760 cm-¹ (Carbonat) und kein phenolisches OH: es ist keine Veränderung gegenüber dem nicht aufgeheizten Spektrum zu sehen. Belichtet man nun 10 Sekunden mit Excimer-Laserlicht der Wellenlänge 248 nm und heizt anschließend 30 Sekunden bei 120°C nach, so ist die Carbonylbande vollständig verschwunden und dafür eine OH-Bande bei 3500 cm-¹ entstanden.

### Beispiel 1

Eine Fotoresistlösung wird aus 1,5 Teilen des, wie oben angegeben, hergestellten Phenyl-bis-(4-t-butoxicarbonyloxiphenyl)-sulfonium-hexafluoroarsenates, 1,5 Teilen eines Novolakes (auf Basis Kresol/Formaldehyd; Viskosität der 50 %igen methanolischen Lösung bei 25°C 40 bis 50 cps) und 7 Teilen Methyl-propylenglykol-acetat hergestellt. Die Lösung wird anschließend durch ein Filter mit einem Porendurchmesser von 0,2 »m filtriert.

Die Resistlösung wird dann auf einen Siliziumwafer mit einem SiO₂-Film mit 3510 Umdrehungen/Minute aufgeschleudert, wobei eine Schichtdicke von 1,00 »m erhalten wird. Der Wafer wird während 1 Minute bei 90°C getrocknet und anschließend mit einer bildmäßig strukturierten Testmaske in Kontakt gebracht und 10 Sekunden mit Excimer-Laserlicht der Wellenlänge 248 nm belichtet. Danach wird 30 Sekunden bei 100°C ausgeheizt und mit einem alkalischen Entwickler vom pH-Wert 13,12 5 Sekunden entwickelt. Die belichteten Bereiche sind vollständig abgelöst, während der Abtrag an den unbelichteten Stellen weniger als 5 % beträgt. Die Resistmuster zeigen eine Auflösung kleiner 1 »m.

### Beispiel 2

Eine Fotoresistlösung wird aus 1 Teil des, wie oben angegeben, hergestellten Phenyl-bis-(4-t-butoxicarbonyloxiphenyl)-sulfonium-hexafluoroarsenates, 3 Teilen des Novolakes (vgl. Beispiel 1) und 7 Teilen Methyl-propylenglykol-acetat hergestellt. Die Lösung wird durch ein Filter mit einem Porendurchmesser von 0,2 »m filtriert und mit 6000 U/min auf einen Siliziumwafer aufgeschleudert. Nach 1 min 90°C Ausheizzeit resultiert eine Schichtdicke von 1,07 »m.

Nach dem Belichten durch eine in Kontakt mit der Waferoberfläche gebrachten Testmaske mit Excimerlaserlicht der Wellenlänge 248 nm während 10 Sekunden wird 30 Sekunden bei 100°C ausgeheizt und anschließend mit einem alkalischen Entwickler mit pH-Wert 13,0 15 Sekunden entwickelt. An den belichteten Stellen ist der Resist vollständig abgetragen, während an den unbelichteten Flächen kein Abtrag stattfindet. Es entstehen Resistmuster guter Qualität.

### Beispiel 3

Eine Resistlösung aus 1,5 Teilen Phenyl-bis-(4-t-butoxicarbonyloxiphenyl-)-sulfonium-hexafluoroarsenat, 1,5 Teilen Poly-(p-hydroxistyrol) (Fa. Polysciences, Inc.) und 7,0 Teile 2-Methoxy-ethylacetat wird hergestellt und durch ein Filter mit einem Porendurchmesser von 0,2 »m filtriert. Eine 1 »m dicke Schicht wird auf einen Siliziumwafer aufgebracht und durch eine Testmaske 10 Sekunden mit Excimer-Laserlicht der Wellenlänge 248 nm belichtet und anschließend 30 Sekunden bei 100°C ausgeheizt. Mit 0,5 %iger Tetramethylammoniumhydroxidlösung lassen sich die belichteten Bereiche selektiv entfernen.

### Beispiel 4

Es wird wie in Beispiel 3 verfahren, jedoch wird anstatt Poly-(p-hydroxistyrol) als Bindemittel ein Copolymeres aus 79 % Methylmethacrylat und 21 % Methacrylsäure (M̅ₙ 29 000) verwendet.

### Beispiel 5

Zur der Resistlösung aus Beispiel 3 gibt man eine kleine Menge Perylen und bringt ebenfalls einen Film der Dicke 1 »m auf einen Siliziumwafer auf. Nach dem Ausheizen (1 Minute bei 90°C) wird mit einer Quecksilberhochdrucklampe bei einer Wellenlänge um 365 nm 2 Minuten durch die Testmaske belichtet und anschließend 1 Minute bei 100°C ausgeheizt. Nach dem Entwickeln entstehen Resistmuster guter Qualität.

### Beispiel 6

Die Eignung der erfindungsgemäßen strahlungsempfindlichen Gemische als elektronenstrahlempfindliche Aufzeichnungsmaterialien wird im folgenden gezeigt:
Eine 1 »m dicke Resistschicht aus 1,5 Teilen Novolak und 1,5 Teilen Phenyl-bis-(4-t-butoxicarbonyloxi-phenyl-)-sulfonium-hexafluoroarsenat wird auf einen Siliziumwafer, der eine dünne SiO₂-Schicht trägt, aufgeschleudert und mit einer Dosis von 20 »C/cm² bestrahlt. Nach einem Ausheizschritt (postbake) von 30 Sekunden bei 100°C genügen 10 Sekunden Entwicklungszeit, um die bestrahlten Bereiche in einem alkalischen Entwickler mit pH = 13,12 vollständig abzulösen.

## Patentansprüche

1. Strahlungsempfindliches Gemisch, enthaltend
a) ein in Wasser unlösliches, in wäßrig-alkalischen Lösungen lösliches polymeres Bindemittel und
b) eine monomere organische Verbindung, deren Löslichkeit in einem wäßrig-alkalischen Entwickler durch Einwirkung von Säure erhöht wird und die sowohl mindestens eine durch Säure spaltbare Gruppierung,
als auch eine Gruppierung enthält, die unter Einwirkung von Strahlung eine starke Säure bildet.

2. Strahlungsempfindliches Gemisch nach Anspruch 1, dadurch gekennzeichnet, daß das polymere Bindemittel (a) ein phenolisches Harz ist.

3. Strahlungsempfindliches Gemisch nach Anspruch 2, dadurch gekennzeichnet, daß das phenolische Harz ein Novolak ist.

4. Strahlungsempfindliches Gemisch nach Anspruch 2, dadurch gekennzeichnet, daß das phenolische Harz Poly-(p-hydroxistyrol), Poly-(p-hydroxi-methylstyrol) oder ein Copolymeres von p-Hydroxistyrol oder p-Hydroxi-methylstyrol ist.

5. Strahlungsempfindliches Gemisch nach Anspruch 1, dadurch gekennzeichnet, daß das polymere Bindemittel (a) ein Methylmethacrylat/Methacrylsäure-Copolymerisat ist.

6. Strahlungsempfindliches Gemisch nach einem der vorhergehenden Ansprüche, dadurch gekennzeichnet, daß die monomere organische Verbindung (b) mindestens eine Oniumsalzgruppierung aufweist.

7. Strahlungsempfindliches Gemisch nach einem der vorhergehenden Ansprüche, dadurch gekennzeichnet, daß die monomere organische Verbindung (b) mindestens eine t-Butylcarbonatgruppierung enthält.

8. Strahlungsempfindliches Gemisch nach einem der Ansprüche 1 bis 6, dadurch gekennzeichnet, daß die monomere organische Verbindung (b) mindestens eine Silylethergruppierung enthält.

9. Strahlungsempfindliches Gemisch nach einem der vorhergehenden Ansprüche, dadurch gekennzeichnet, daß es als organische Verbindung (b) mindestens eine Verbindung der allgemeinen Formel (I) enthält 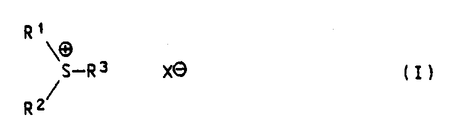 worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet.

10. Strahlungsempfindliches Gemisch nach einem der Ansprüche 1 bis 9, dadurch gekennzeichnet, daß die organische Verbindung (b) ein Dimethyl-4-t-butoxicarbonyloxiphenyl-sulfoniumsalz mit Hexafluoroarsenat, Hexafuoroantimonat, Hexafluorophosphat und/oder Tetrafluoroborat als Gegenion ist.

11. Strahlungsempfindliches Gemisch nach einem der Ansprüche 1 bis 9, dadurch gekennzeichnet, daß die organische Verbindung (b) ein Phenyl-bis-(4-t-butoxicarbonyl-oxiphenyl-)sulfoniumsalz mit Hexafluoroarsenat, Hexafluoroantimonat, Hexafluorophosphat und/oder Tetrafluoroborat als Gegenion ist.

12. Strahlungsempfindliches Gemisch nach einem der Ansprüche 1 bis 9, dadurch gekennzeichnet, daß die organische Verbindung (b) ein Tris-(4-t-butoxicarbonyloxiphenyl-)-sulfoniumsalz mit Hexafluoroarsenat, Hexafluoroantimonat, Hexafluorophosphat und/oder Tetrafluoroborat als Gegenion ist.

13. Strahlungsempfindliches Gemisch nach einem der Ansprüche 1 bis 9, dadurch gekennzeichnet, daß die Verbindung (b) ein 1-Naphthyl-4-trimethylsilyloxitetramethylen-sulfoniumsalz mit Hexafluoroarsenat, Hexafluoroantimonat, Hexafluorophosphat und/oder Tetrafluoroborat als Gegenion ist.

14. Strahlungsempfindliches Gemisch nach einem der Ansprüche 1 bis 13, dadurch gekennzeichnet, daß es 25 bis 95 Gew.% des polymeren Bindemittels (a) und 5 bis 75 Gew.% der organischen Verbindung (b) enthält.

15. Strahlungsempfindliches Gemisch nach einem der vorhergehenden Ansprüche, dadurch gekennzeichnet, daß es zusätzlich einen Sensibilisator enthält, der Strahlung absorbiert und auf die organische Verbindung (b) überträgt.

16. Strahlungsempfindliches Gemisch gemäß Anspruch 15, dadurch gekennzeichnet, daß der Sensibilisator eine polycyclische aromatische Verbindung wie Perylen oder Pyren ist.

17. Verwendung der strahlungsempfindlichen Gemische nach einem der Ansprüche 1 bis 15 in lichtempfindlichen Beschichtungsmaterialien.

18. Verfahren zur Herstellung von Reliefmustern und Reliefbildern, dadurch gekennzeichnet, daß man als lichtempfindliche Beschichtungsmaterialien strahlungsempfindliche Gemische nach einem der Ansprüche 1 bis 15 verwendet.

19. Verfahren zur Herstellung von Reliefmustern nach Anspruch 18, dadurch gekennzeichnet, daß nach der Belichtung auf Temperaturen zwischen 60 und 120°C erhitzt wird.

## Claims

1. A radiation-sensitive mixture containing
a) a polymeric binder which is insoluble in water but soluble in aqueous alkaline solutions and
b) a monomeric organic compound whose solubility in an aqueous alkaline developer is increased by the action of an acid and which contains both one or more acid-cleavable groups.
and a group which forms a strong acid under the action of radiation.

2. A radiation-sensitive mixture as claimed in claim 1, wherein the polymeric binder (a) is a phenolic resin.

3. A radiation-sensitive mixture as claimed in claim 2, wherein the phenolic resin is a novolak.

4. A radiation-sensitive mixture as claimed in claim 2, wherein the phenolic resin is poly-(p-hydroxystyrene), poly- (p-hydroxymethylstyrene) or a copolymer of p-hydroxystyrene or p-hydroxymethylstyrene.

5. A radiation-sensitive mixture as claimed in claim 1, wherein the polymeric binder (a) is a methyl methacrylate/methacrylic acid copolymer.

6. A radiation-sensitive mixture as claimed in any of the preceding claims, wherein the monomeric organic compound (b) has one or more onium salt groups.

7. A radiation-sensitive mixture as claimed in any of the preceding claims, wherein the monomeric organic compound (b) contains one or more tert-butyl carbonate groups.

8. A radiation-sensitive mixture as claimed in any of claims 1 to 6, wherein the monomeric organic compound (b) contains one or more silyl ether groups.

9. A radiation-sensitive mixture as claimed in any of the preceding claims, which contains, as organic compound (b), one or more compounds of the formula (I) 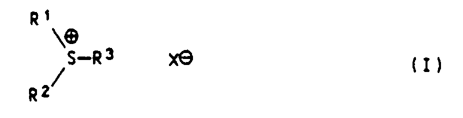 where R¹, R² and R³ are identical or different and are aliphatic and/or aromatic radicals which may contain hetero atoms, or two of the radicals R¹ to R³ are bonded to one another to form a ring, with the proviso that one or more of the radicals R¹ to R³ contain one or more acid-cleavable groups, and one of the radicals R¹ to R³ may be bonded to one or more further sulfonium salt radicals, if desired via acid-cleavable groups, and X^{⊖} is a non-nucleophilic counter-ion.

10. A radiation-sensitive mixture as claimed in any of claims 1 to 9, wherein the organic compound (b) is a dimethyl-4-tertbutoxycarbonyloxyphenylsulfonium salt with hexafluoroarsenate, hexafluoroantimonate, hexafluorophosphate and/or tetrafluoborate as a counter-ion.

11. A radiation-sensitive mixture as claimed in any of claims 1 to 9, wherein the organic compound (b) is a phenylbis- (4-tert-butoxycarbonyloxphenyl)-sulfonium salt with hexafluoroarsenate, hexafluoroantimonate, hexafluorophosphate and/or tetrafluoborate as a counter-ion.

12. A radiation-sensitive mixture as claimed in any of claims 1 to 9, wherein the organic compound (b) is a tris-(4-tert-butoxycarbonyloxyphenyl)-sulfonium salt with hexafluoroarsenate, hexafluoroantimonate, hexafluorophosphate and/or tetrafluoborate as a counter-ion.

13. A radiation-sensitive mixture as claimed in any of claims 1 to 9, wherein the compound (b) is a 1-naphthyl-4-trimethyl-silyloxytetramethylenesulfonium salt with hexafluoroarsenate, hexafluoroantimonate, hexafluorophosphate and/or tetrafluoborate as a counter-ion.

14. A radiation-sensitive mixture as claimed in any of claims 1 to 13, which contains from 25 to 95% by weight of the polymeric binder (a) and from 5 to 75% by weight of the organic compound (b).

15. A radiation-sensitive mixture as claimed in any of the preceding claims, which additionally contains a sensitizer which absorbs radiation and transfers it to the organic compound (b).

16. A radiation-sensitive mixture as claimed in claim 15, wherein the sensitizer is a polycyclic aromatic compound, such as perylene or pyrene.

17. Use of the radiation-sensitive mixture as claimed in any of claims 1 to 15 in a photosensitive coating material.

18. A process for the production of a relief pattern or relief image, wherein the photosensitive coating material used is a radiation-sensitive mixture as claimed in any of claims 1 to 15.

19. A process for the production of a relief pattern as claimed in claim 18, wherein exposure is followed by heating to 60-120°C.

## Revendications

1. Mélange sensible aux rayonnements contenant :
a) un liant polymère insoluble dans l'eau mais soluble dans des solutions aqueuses alcalines, et
b) un composé organique monomère dont la solubilité dans un révélateur aqueux alcalin est accrue sous l'action d'un acide et qui contient à la fois au moins un groupement scindable sous l'action d'un acide ainsi qu'un groupement formant un acide fort sous l'action des rayonnements.

2. Mélange sensible aux rayonnements selon la revendication 1, caractérisé en ce que le liant polymère a) est une résine phénolique.

3. Mélange sensible aux rayonnements selon la revendication 2, caractérisé en ce que la résine phénolique est un novolaque.

4. Mélange sensible aux rayonnements selon la revendication 2, caractérisé en ce que la résine phénolique est un poly-(p-hydroxystyrène), un poly-(p-hydroxy-méthylstyrène) ou un copolymère du p-hydroxystyrène ou du p-hydroxy-méthylstyrène.

5. Mélange sensible aux rayonnements selon la revendication 1, caractérisé en ce que le liant polymère a) est un copolymère méthacrylate de méthyle/acide méthacrylique.

6. Mélange sensible aux rayonnements selon une des revendications qui précèdent, caractérisé en ce que le composé organique monomère b) contient au moins un groupement sel d'onium.

7. Mélange sensible aux rayonnements selon une des revendications qui précèdent, caractérisé en ce que le composé organique monomère b) contient au moins un groupement tert-butylcarbonate.

8. Mélange sensible aux rayonnements selon une des revendications 1 à 6, caractérisé en ce que le composé organique monomère b) contient au moins un groupement éther silylique.

9. Mélange sensible aux rayonnements selon une des revendications qui précèdent, caractérisé en ce qu'il contient en tant que composé organique b) au moins un composé de formule générale I 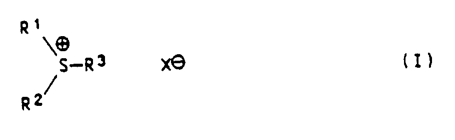 dans laquelle R¹, R² et R³, ayant des significations identiques ou différentes, représentent chacun un radical aliphatique et/ou aromatique contenant le cas échéant des hétéroatomes, ou bien deux des groupes R¹ à R³ sont reliés entre eux avec formation d'un cycle, sous réserve qu'au moins un des groupes R¹ à R³ contient au moins un groupement scindable sous l'action d'un acide, l'un des groupes R¹ à R³ pouvant être relié à un ou plusieurs autres radicaux de sels de sulfonium, éventuellement par l'intermédiaire de groupements scindables sous l'action des acides, et X^{⊖} représente un contre-ion non nucléophile.

10. Mélange sensible aux rayonnements selon une des revendications 1 à 9, caractérisé en ce que le composé organique b) est un sel de diméthyl-4-tert-butoxycarbonyloxyphényl-sulfonium portant en tant que contre-ion hexafluoroarséniate, hexafluoroantimoniate, hexafluorophosphate et/ou tétrafluoroborate.

11. Mélange sensible aux rayonnements selon une des revendications 1 à 9, caractérisé en ce que le composé organique b) est un sel de phényl-bis-(4-tert-butoxycarbonyl-oxyphényl)-sulfonium avec en tant que contre-ion hexafluoroarséniate, hexafluoroantimoniate, hexafluorophosphate et/ou tétrafluoroborate.

12. Mélange sensible aux rayonnements selon une des revendications 1 à 9, caractérisé en ce que le composé organique b) est un sel de tris-(4-tert-butoxycarbonyloxyphényl)-sulfonium avec en tant que contre-ion hexafluoroarséniate, hexafluoroantimoniate, hexafluorophosphate et/ou tétrafluoro-borate.

13. Mélange sensible aux rayonnements selon une des revendications 1 à 9, caractérisé en ce que le composé b) est un sel de 1-naphtyl-4-triméthylsilyloxytétraméthylène-sulfonium avec en tant que contre-ion hexafluoroarséniate, hexafluoroantimoniate, hexafluorophosphate et/ou tétrafluoroborate.

14. Mélange sensible aux rayonnements selon une des revendications 1 à 13, caractérisé en ce qu'il contient de 25 à 95 % en poids du liant polymère a) et de 5 à 75 % en poids du composé organique b).

15. Mélange sensible aux rayonnements selon une des revendications qui précèdent, caractérisé en ce qu'il contient en outre un sensibilisant qui absorbe le rayonnement et le transfère au composé organique b).

16. Mélange sensible aux rayonnements selon la revendication 15, caractérisé en ce que le sensibilisant est un composé aromatique polycyclique comme le pérylène ou pyrène.

17. Utilisation des mélanges sensibles aux rayonnements selon une des revendications 1 à 15 en tant que matériaux de revêtement photosensibles.

18. Procédé de préparation de modèles en relief et d'images en relief, caractérisé en ce que l'on utilise en tant que matériaux de revêtement photosensibles des mélanges sensibles aux rayonnements selon une des revendications 1 à 15.

19. Procédé de préparation de modèles en relief selon la revendication 18, caractérisé en ce que, après l'exposition à la lumière, on chauffe à des températures de 60 à 120°C.
